(19)

**Europäisches Patentamt**
**European Patent Office**
**Office européen des brevets**

(11)  **EP 3 437 770 B1**

(12)  **EUROPEAN PATENT SPECIFICATION**

(45) Date of publication and mention
of the grant of the patent:
**30.08.2023  Bulletin 2023/35**

(51) International Patent Classification (IPC):
**B23B 27/14** *(2006.01)*      **B22F 3/24** *(2006.01)*
**C22C 29/16** *(2006.01)*      **C04B 41/87** *(2006.01)*
**C04B 41/89** *(2006.01)*

(21) Application number: **16897057.2**

(22) Date of filing: **02.12.2016**

(52) Cooperative Patent Classification (CPC):
(C-Sets available)
**C23C 14/0635; C04B 35/5831; C04B 35/645;
C04B 37/026; C04B 41/009; C04B 41/5063;
C04B 41/52; C04B 41/87; C04B 41/89;
C23C 14/0641;** B23B 2226/125; B23B 2228/10;
C04B 2235/3275; C04B 2235/3813;
C04B 2235/3847;      (Cont.)

(86) International application number:
**PCT/JP2016/085887**

(87) International publication number:
**WO 2017/168841 (05.10.2017 Gazette 2017/40)**

(54)  **SURFACE-COATED CUBIC BORON NITRIDE SINTERED MATERIAL, AND CUTTING TOOL INCLUDING THE SAME**

OBERFLÄCHENBESCHICHTETER SINTERKÖRPER AUS KUBISCHEM BORNITRID UND DIESEN ENTHALTENDES SCHNEIDWERKZEUG

CORPS FRITTÉ EN NITRURE DE BORE REVÊTU EN SURFACE ET OUTIL DE COUPE COMPRENANT CELUI-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **30.03.2016  JP 2016068327**

(43) Date of publication of application:
**06.02.2019  Bulletin 2019/06**

(73) Proprietor: **Sumitomo Electric Hardmetal Corp.
Itami-shi, Hyogo 664-0016 (JP)**

(72) Inventors:
• **TAKAHAMA, Kazushi
Itami-shi
Hyogo 664-0016 (JP)**
• **SETOYAMA, Makoto
Itami-shi
Hyogo 664-0016 (JP)**
• **OKAMURA, Katsumi
Itami-shi
Hyogo 664-0016 (JP)**

(74) Representative: **Boult Wade Tennant LLP
Salisbury Square House
8 Salisbury Square
London EC4Y 8AP (GB)**

(56) References cited:
WO-A1-2010/150335      WO-A1-2012/005275
WO-A1-2013/069657      JP-A- 2015 123 530
US-A1- 2013 108 850

(52) Cooperative Patent Classification (CPC): (Cont.)
C04B 2235/3865; C04B 2235/5436; C04B 2235/80;
C04B 2235/94; C04B 2237/122; C04B 2237/124;
C04B 2237/361; C04B 2237/401; C23C 14/325

C-Sets
**C04B 41/009, C04B 35/5831;**
**C04B 41/5063, C04B 41/4529, C04B 41/5062;**
**C04B 41/52, C04B 41/4529, C04B 41/5061,**
**C04B 41/5068;**
**C04B 41/52, C04B 41/4529, C04B 41/5063,**
**C04B 41/5068**

**Description**

TECHNICAL FIELD

The present invention relates to a surface-coated cubic boron nitride sintered material, and to a cutting tool including the surface-coated cubic boron nitride sintered material.

BACKGROUND ART

As one of cutting tools, there is a cutting tool using a cubic boron nitride sintered material (hereinafter, also referred to as "cBN sintered material") including cubic boron nitride (hereinafter, also referred to as "cBN") and a binder, as a substrate. The properties of a cBN sintered material tend to differ largely depending on the proportion of cBN particles contained in the cBN sintered material. For example, in a case where the content ratio of cBN particles in a cBN sintered material is high, although high wear resistance can be exerted, the heat resistance tends to be insufficient. On the other hand, in a case where the content ratio of cBN particles is low, the wear resistance is lowered as compared with the former case, but the heat resistance can be increased. This is because the cBN particles mainly contribute to the hardness of the cBN sintered material, and the binder mainly contributes to the heat resistance of the cBN sintered material.

Wear resistance, heat resistance, and the like are important factors as the cutting performance. For this reason, in the technical field, the type of a cBN sintered material to be used for cutting work is selected depending on the material quality of a work material, the processing precision to be required, and the like. For example, in cutting work in which the cutting edge temperature becomes remarkably high as in the case of high-speed machining of a hardened steel, a cBN sintered material (hereinafter, also referred to as "Low-cBN sintered material") having a low content ratio of cBN particles (the content ratio of binder is high), and being more excellent in the heat resistance is applied. On the other hand, in cutting work in which the cutting edge temperature does not increase so much as in the case of precision machining of cast iron or a sintered alloy, a cBN sintered material (hereinafter, also referred to as "High-cBN sintered material") having a high content ratio of cBN particles, and being more excellent in the wear resistance is applied.

Further, in recent years, a technique for improving the cutting performance by providing a coating on a surface of a cBN sintered material has been developed. For example, in Japanese Patent Laying-Open No. 2009-095889 (PTD 1), a technique for suppressing the falling of cBN particles by providing a characteristic coating on a surface of a High-cBN sintered material has been disclosed. In addition, in Japanese Patent Laying-Open No. 2015-085465 (PTD 2), a technique for improving the finished surface roughness of a work material by providing a characteristic coating on a surface of a Low-cBN sintered material has been disclosed.

US2013/108850 discloses a a coated cBN sintered body tool.

CITATION LIST

PATENT DOCUMENT

PTD 1: Japanese Patent Laying-Open No. 2009-095889
PTD 2: Japanese Patent Laying-Open No. 2015-085465

SUMMARY OF INVENTION

The surface-coated cBN sintered material according to one embodiment of the present disclosure includes a cBN sintered material, and a coating covering a surface of the cBN sintered material, in which the cBN sintered material contains cBN particles and a binder, a proportion of the cBN particle in the cBN sintered material is more than or equal to 85% by volume and less than or equal to 98% by volume, the binder contains a first compound including at least one element of Al and Cr and at least one element selected from the group consisting of N, B and O, the coating contains a layer A in contact with the cBN sintered material, and the layer A is constituted of $Al_{x1}Cr_{y1}M_{z1}C_{a1}N_{b1}O_{c1}$ provided that M is greater than or equal to one kind of Ti, V, Nb and Si, and $0.25 \leq x1 \leq 0.75$, $0.25 <\_ y1 \leq 0.75$, $0 \leq z1 \leq 0.5$, $x1 + y1 + z1 = 1$, $0 \leq a1 \leq 0.5$, $0.5 \leq b1 \leq 1$, $0 \leq c \leq 0.1$ and $a1 + b1 + c1 = 1$ are satisfied, the thickness of said layer A is 0.5 to 10 $\mu$m.

The cutting tool according to one embodiment of the present disclosure is a cutting tool including the above-described surface-coated cBN sintered material.

BRIEF DESCRIPTION OF DRAWINGS

Fig. 1 is a schematic perspective view of a surface-coated cBN sintered material according to a first embodiment.
Fig. 2 is a schematic arrow sectional view regarding a line X-X in Fig. 1.
Fig. 3 is a schematic local sectional view for describing a constitution of a cBN sintered material.
Fig. 4 is a schematic local sectional view of the surface-coated cBN sintered material to which honing processing has been applied.
Fig. 5 is a schematic local sectional view of a surface-coated cBN sintered material according to a second embodiment.
Fig. 6 is a schematic local sectional view of a surface-coated cBN sintered material according to a third embodiment.
Fig. 7 is a schematic local sectional view of other surface-coated cBN sintered materials according to the third embodiment.
Fig. 8 is a schematic local sectional view of a cutting tool according to a fifth embodiment.
Fig. 9 is a schematic local sectional view of other cutting tools according to the fifth embodiment.

DESCRIPTION OF EMBODIMENTS

[Problem to be solved by the present disclosure]

By the way, in precision machining using a High-cBN sintered material, the generation of burrs frequently becomes a problem. Burrs are projections generated on a finished surface (surface after cutting work) of a work material to be a precision part, and cause a decrease in precision of the precision part. For this reason, in a case of fabricating a precision part by using a High-cBN sintered material, burrs are removed from the finished surface after cutting work by post-treatment such as polishing. Such post-treatment causes an increase in production cost and production processes.
In view of the circumstances as described above, an object of the present disclosure is to provide a surface-coated cubic boron nitride sintered material (hereinafter, also referred to as "surface-coated cBN sintered material") for suppressing the generation of burrs in a work material, and a cutting tool including the surface-coated cubic boron nitride sintered material.

[Effect of the present disclosure]

According to the above, a surface-coated cBN sintered material for suppressing the generation of burrs in a work material when applied to cutting processing, and a cutting tool including the surface-coated cBN sintered material can be provided.

[Description of embodiment of the present invention]

First, the embodiments of the present invention will be listed, and described.

[1] The surface-coated cBN sintered material according to one embodiment of the present disclosure includes a cBN sintered material, and a coating covering a surface of the cBN sintered material, in which the cBN sintered material contains a cBN particle and a binder, a proportion of the cBN particle in the cBN sintered material is more than or equal to 85% by volume and less than or equal to 98% by volume, the binder contains a first compound including at least one element of Al and Cr and at least one element selected from the group consisting of N, B and O, the coating contains a layer A in contact with the cBN sintered material, and the layer A is constituted of $Al_{x1}Cr_{y1}M_{z1}C_{a1}N_{b1}O_{c1}$ provided that M is greater than or equal to one kind of Ti, V, Nb and Si, and $0.25 \leq x1 \leq 0.75$, $0.25 \leq y1 \leq 0.75$, $0 \leq z1 \leq 0.5$, $x1 + y1 + z1 = 1$, $0 \leq a1 \leq 0.5$, $0.5 \leq b1 \leq 1$, $0 \leq c1 \leq 0.1$, and $a1 + b1 + c1 = 1$ are satisfied, the thickness of said layer A is 0.5 to 10 $\mu$m.
According to the above-described surface-coated cBN sintered material, the generation of burrs in a work material can be suppressed. Although the reason for this is not clear, according to the research results of the present inventors, it has been confirmed that the wear resistance of the above-described surface-coated cBN sintered material is improved on the flank face side as compared with the wear resistance of an ordinary cBN sintered material, and the crater wear is caused on the rake face side. According to this, it has been inferred that in the precision machining using the surface-coated cBN sintered material, since the wear behavior varies between the rake face side and the flank face side, the decrease with time in the cutting performance of the surface-coated cBN sintered material is suppressed, and along with this, the generation of burrs in a work material is suppressed.

[2] In the above-described surface-coated cBN sintered material, a proportion of the cBN particles in the cBN sintered material is preferably 90 to 98% by volume (greater than or equal to 90% by volume and less than or equal to 98% by volume). According to this, the surface-coated cBN sintered material can have higher hardness.

[3] The binder in the above-described surface-coated cBN sintered material preferably contains a second compound including at least one element of W and Co and at least one element selected from the group consisting of N, B and O. The cBN sintered material having the binder described above has high bonding strength between cBN particles, therefore, exerts excellent sinterability, and as a result, can have higher strength.

[4] In the above-described surface-coated cBN sintered material, a proportion of the first compound in the binder is preferably 0.5 to 100% by mass. According to this, the adhesion between the cBN sintered material and the coating is improved, and the surface-coated cBN sintered material is excellent in the peeling resistance.

[5] The first compound in the above-described surface-coated cBN sintered material is preferably at least one kind selected from the group consisting of AlCrN, AlN, and CrN. According to this, the peeling resistance of the surface-coated cBN sintered material is improved.

[6] As to the above-described surface-coated cBN sintered material, in a cross section of the surface-coated cBN sintered material, when the region located on an interface where one surface of the cBN sintered material and the coating are in contact with each other, and sandwiched between a first virtual straight line segment having a length of 500 $\mu$m, and a second virtual straight line segment obtained by moving the first virtual straight line segment parallelly toward the inside of the cBN sintered material by 10 $\mu$m, is observed, it is preferred that voids are present in the region, and further a proportion of the voids in the region is 0.1 to 5% by area. According to this, the peeling resistance of the surface-coated cBN sintered material is improved.

[7] In the above-described surface-coated cBN sintered material, surface roughness Ra of the outermost surface of the coating is preferably 0.005 to 0.2 $\mu$m. According to this, the peeling resistance of the surface-coated cBN sintered material is improved.

[8] In the above-described surface-coated cBN sintered material, preferably, the coating further contains a layer B, and the layer B is constituted of $Ti_{x2}Al_{y2}M_{z2}N$ provided that M is greater than or equal to one kind of V and Si, and $0.25 \leq x2 \leq 0.65$, $0.35 \leq y2 \leq 0.75$, $0 \leq z2 \leq 0.2$, and $x2 + y2 + z2 = 1$ are satisfied. According to this, the wear resistance of the surface-coated cBN sintered material is further improved.

[9] In the above-described surface-coated cBN sintered material, preferably, the coating further contains a layer C, and the layer C is constituted of $Ti_{x3}M_{y3}C_{a3}N_{b3}$ provided that M is greater than or equal to one kind of Cr, Nb, and W, and $0.3 \leq x3 \leq 1$, $0 < y3 \leq 0.7$, $x3 + y3 = 1$, $0 \leq a3 \leq 1$, $0 \leq b3 \leq 1$, and $a3 + b3 = 1$ are satisfied. According to this, the wear resistance, particularly the wear resistance under a high-temperature environment, of the surface-coated cBN sintered material is further improved.

[10] The cutting tool according to one embodiment of the present disclosure includes the above-described surface-coated cBN sintered material. According to this cutting tool, the generation of burrs in a work material can be suppressed.

[Details of embodiment of the present invention]

Hereinafter, one embodiment of the present invention (hereinafter referred to as "the present embodiment") will be described in detail, but the present embodiment is not limited to these embodiments. In addition, in the present specification, those not particularly specifying the atom ratio in a chemical formula such as "AlCrN", "AlN", "TiN", or the like do not indicate that the atom ratio of each element is only "1", but indicate that all of the conventionally known atom ratios are included.

[First embodiment]

<Surface-coated cBN sintered material>

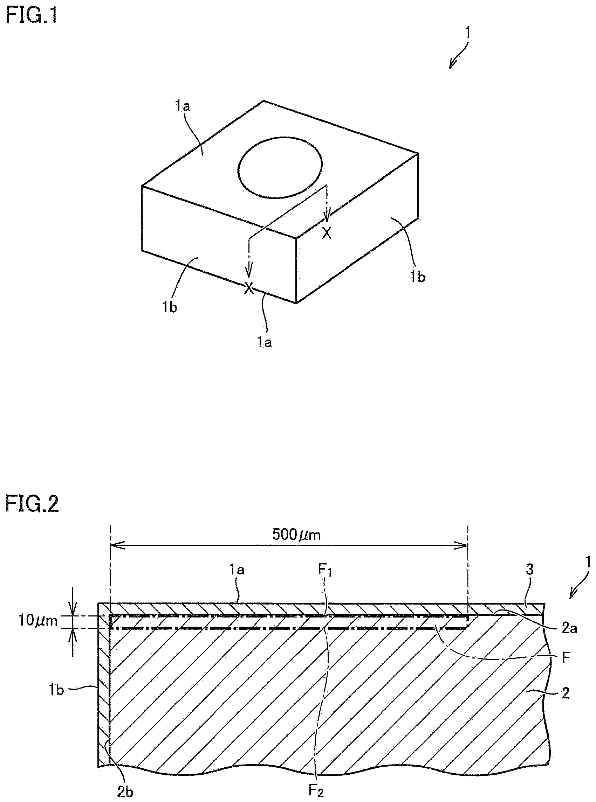

With reference to Figs. 1 to 3, the surface-coated cBN sintered material according to the present embodiment will be described. As shown in Fig. 1, a surface-coated cBN sintered material 1 has surfaces including a top surface, a bottom surface, and four side surfaces, and as a whole, has a quadrangular prism shape being slightly thin in the vertical direction. Further, in surface-coated cBN sintered material 1, a through hole penetrating the top and bottom surfaces is formed. In surface-coated cBN sintered material 1 of the present embodiment, each of the top surface and bottom surface forms a rake face 1a, and each of the four side surfaces forms a flank face 1b. Moreover, the vicinity of the ridgeline where rake face 1a and the flank face 1b intersect becomes a cutting edge region that functions as a cutting edge.

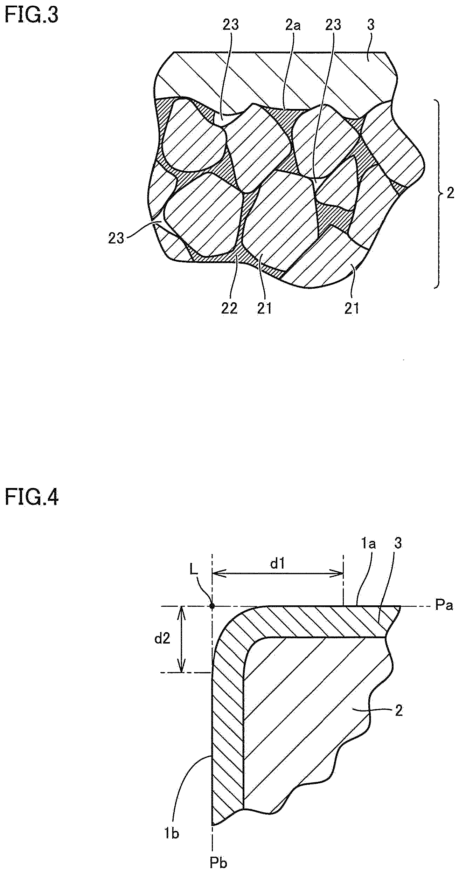

In the present specification, a region obtained by combining rake face 1a located within 3000 $\mu$m from a ridgeline and the flank face 1b located within 1500 $\mu$m from the ridgeline is set to be a cutting edge region. Note that since the surface-coated cBN sintered material of the present embodiment has a sharp edge shape, a ridgeline of rake face 1a and the flank face 1b is present, but in a case where a process such as honing processing or the like has been applied to a cutting edge, the above-described ridgeline is not present. In such a case, as shown in Fig. 4, a virtual ridgeline L where the virtual face Pa containing rake face 1a and the virtual face the Pb containing flank face 1b intersect is regarded as the above-described ridgeline. Further, a region obtained by combining rake face 1a located within 3000 μm from the virtual ridgeline L (shown by a distance d1 in Fig. 4) and the flank face 1b located within 1500 μm from the virtual ridgeline L (shown by a distance d2 in Fig. 4) is set to be a cutting edge region.

As shown in Fig. 2, surface-coated cBN sintered material 1 includes a cBN sintered material 2, and a coating 3 covering a surface of the cBN sintered material. Coating 3 may cover all or part of the surfaces of cBN sintered material 2. However, it is assumed that coating 3 is provided at least on rake face 1a and flank face 1b constituting a cutting edge region. Coating 3 of the present embodiment includes only a layer A described later.

<cBN Sintered material>

As shown in Fig. 2, cBN sintered material 2 has a rake face 2a and a flank face 2b. It is similar to the above description that the vicinity of the ridgeline where rake face 2a and flank face 2b intersect constitutes a cutting edge region. Further, as shown in Fig. 3, cBN sintered material 2 contains cBN particles 21 and a binder 22. Note that cBN sintered material 2 may contain unavoidable impurities.

<cBN Particles>

cBN particles 21 are crystal grains consisting of cBN. The content ratio of cBN particles 21 in cBN sintered material 2 is more than or equal to 85% by volume and less than or equal to 98% by volume. That is, cBN sintered material 2 is a High-cBN sintered material. The content ratio of cBN particles 21 is preferably 90 to 98% by volume. According to this, cBN sintered material 2 is more excellent in the hardness, and as a result, the wear resistance of surface-coated cBN sintered material 1 is improved.

The content ratio of cBN particles 21 in cBN sintered material 2 is determined as follows. First, an arbitrary position of surface-coated cBN sintered material 1 is cut to prepare a sample including a cross section of cBN sintered material 2. However, in the cross section, the vicinity of the surface (within 10 μm from the surface) of cBN sintered material 2 is not to be contained. This is because there are some cases where voids 23 described later are present in the vicinity of the surface, and the content ratio of cBN particles is hardly unambiguously determined. In addition, in a case where cBN sintered material 2 is in contact with a cemented carbide, in the above-described cross section, the range within 100 μm from the interface with the cemented carbide is not to be contained. This is because there is a case where superhard components of a cemented carbide dissolve in the cBN sintered material in the vicinity of the cemented carbide.

For the fabrication of a cross section of cBN sintered material 2, a focused ion beam device, a cross-section polisher device, and the like can be used. Next, the cross section of cBN sintered material 2 is observed by a scanning electron microscope (SEM) at 2000 times, and a backscattered electron image is obtained. In the backscattered electron image, the region where cBN particles 21 are present is the black area, and the region where binder 22 is present is the gray area or the white area.

Next, by performing binarization processing on the above-described backscattered electron image using image analysis software (for example, "WinROOF" by MITANI CORPORATION), the area occupied by cBN particles 21 is determined. By substituting the obtained area occupied by cBN particles 21 in the following equation (1), the content volume ratio of cBN particles 21 in cBN sintered material 2 can be obtained.

$$(\text{Content volume ratio of cBN particles 21 in cBN sintered material 2}) = (\text{Area occupied by cBN particles 21}) \div (\text{Area of the backscattered electron image taken}) \times 100$$

$$\cdots \text{equation (1)}$$

The particle diameter of cBN particles 21 is not particularly limited, but d50 is preferably 0.5 to 2 μm from the viewpoint of increasing the strength. Further, the variation of particle diameter of the cBN particles is preferably small. This is because the properties of cBN sintered material 2 are homogenized. For example, it is preferred that d50 satisfies 0.5 to 2 μm, and further d90 satisfies 1.0 to 3.5 μm. More preferably, d90 is 1.5 to 3.0 μm.

d50 and d90 of cBN particles 21 are obtained as follows. First, a sample including a cross section of cBN sintered material 2 is prepared in accordance with the procedure for determining the content ratio of cBN particles 21, and a backscattered electron image is obtained. The equivalent circle diameter of each black area in the backscattered electron image is calculated by using image analysis software (for example, "WinROOF" by MITANI CORPORATION). The equivalent circle diameter of each of the greater than or equal to 100 pieces of cBN particles 21 is calculated by observing greater than or equal to 5 fields of view, and then each circle equivalent diameter is drawn side by side from the minimum value to the maximum value as a cumulative distribution. In the cumulative distribution, the particle diameter at which the cumulative area is 50% is set to be d50, and the particle diameter at which the cumulative area is 90% is set to be d90. Note that equivalent circle diameter means the diameter of a circle having the same area as the area of each of cBN particles 21.

<Binder>

Binder 22 has a role of bonding cBN particles 21 to each other. The content ratio of binder 22 is not limited as long as the role is fulfilled. However, in the present embodiment, since the content ratio of cBN particles 21 is more than or equal to 85% by volume, the upper limit value of the content ratio of binder 22 is 15% by volume.

Binder 22 contains a first compound including at least one element of Al and Cr and at least one element selected from the group consisting of N, B and O. Examples of the first compound include AlCrN, AlN, CrN, $Al_2O_3$, $AlB_2$, $Cr_2O_3$, and $CrB_2$. Since such binder 22 has favorable affinity for a layer A (described later) containing Al and Cr, and is excellent in the adhesion with the layer A, the peeling resistance of surface-coated cBN sintered material 1 can be improved.

The first compound is preferably at least one kind selected from the group consisting of AlCrN, AlN, and CrN, more preferably AlCrN and AlN, and particularly preferably AlCrN. In this case, the first compound is particularly excellent in the improvement of peeling resistance. Further, the content ratio of the first compound in binder 22 is preferably 0.5 to 100% by mass.

The kind and content ratio (% by mass) of the compound contained in binder 22 can be specified as follows. First, a sample including a cross section of cBN sintered material 2 is prepared in accordance with the procedure for determining the content ratio of cBN particles 21. Next, the kind and content ratio of each of elements are calculated by using an energy dispersive X-ray device attached with SEM or a transmission electron microscope (TEM). Subsequently, the kind and content ratio of each compound are estimated by using an X-ray diffraction apparatus, and the content ratio of each compound is calculated from these results.

Binder 22 may further contain a second compound including at least one element of W and Co and at least one element selected from the group consisting of N, B and O. In a case where binder 22 contains the second compound, the bonding strength between the cBN particles is high, therefore, excellent sinterability is exerted, and as a result, high strength can be provided. The content ratio of the second compound in binder 22 is preferably less than or equal to 95.5%. Further, binder 22 may contain other conventionally known compounds.

<Layer A>

Coating 3 is a layer A in contact with cBN sintered material 2. The layer A is constituted of $Al_{x1}Cr_{y1}M_{z1}C_{a1}N_{b1}O_{c1}$ (provided that M is greater than or equal to one kind of Ti, V, Nb and Si, and $0.25 \leq x1 \leq 0.75$, $0.25 \leq y1 \leq 0.75$, $0 \leq z1 \leq 0.5$, $x1 + y1 + z1 = 1$, $0 \leq a1 \leq 0.5$, $0.5 \leq b1 \leq 1$, $0 \leq c1 \leq 0.1$, and $a1 + b1 + c1 = 1$ are satisfied).

In a case where precision machining of cast iron or a sintered alloy is continuously performed by using a High-cBN sintered material, the flank face tends to be easily worn. That is, even if a High-cBN sintered material exhibits excellent cutting performance at the time of starting the cutting, there is a tendency that the wear of a flank face is caused while continuing the precision machining by using the High-cBN sintered material. When the flank face is worn out, the cutting resistance between the cBN sintered material and the work material becomes large, and along with this, the generation of burrs on a finished surface in the work material becomes prominent, or large burrs are generated. On the other hand, even when the precision machining of cast iron or a sintered alloy is continuously performed by using surface-coated cBN sintered material 1 having a layer A (that is, surface-coated cBN sintered material in the above [1]), the generation of burrs as described above is suppressed.

Although the reasons for the above have not been elucidated clearly, but it is considered that firstly, the oxidation of binder 22 is suppressed due to the presence of ArCrN that is excellent in the oxidation resistance, and according to this, flank wear of cBN sintered material 1 accompanying the oxidation of binder 22 is suppressed. In addition, according to the research by the present inventors, it has been confirmed that when the cutting work is performed by using surface-coated cBN sintered material 1, the high wear resistance is exerted on the flank face 1b side, but the crater wear is caused (accelerated) on the rake face 1a side. In general, the crater wear is hard to occur in the High-cBN sintered material. For this reason, it is a surprising phenomenon that the behavior as described above is observed on the rake face 1a side together with the behavior on the flank face 1b side.

Further, from the above, the following is inferred. That is, according to surface-coated cBN sintered material 1, an increase in the cutting resistance is suppressed by the improvement of wear resistance on the flank face 1b side, and further the sharp shape of the cutting edge is maintained or the sharpness of the cutting edge improves by the generation of crater wear on the rake face 1a side. For this reason, in surface-coated cBN sintered material 1, by a synergistic effect of suppressing the increase in the cutting resistance and maintaining (or improving) the sharpness of the cutting edge, the decrease with time in the cutting performance is suppressed, and as a result, the generation of burrs in the work material is suppressed.

Herein, the crater wear is not usually generated in the High-cBN sintered material as described above. On the other hand, in surface-coated cBN sintered material 1, it has been confirmed that the crater wear is generated due to the falling off of also cBN sintered material 1 located under coating 3 together with the falling off of coating 3. For this reason, it is considered that to the generation of the crater wear, not only the characteristics specific to the layer A but also the height of the adhesion of the layer A with cBN sintered material 2 is related. In addition, in the precision machining of cast iron or a sintered alloy, there is a tendency that the temperature on the rake face 1a side is higher than the temperature on the flank face 1b side. According to this, it can also be considered that the original strength of the layer A is maintained on the flank face 1b side, but on the rake face 1a side, the strength of the layer A is lowered in an appropriate range so that the crater wear is caused.

The thickness of coating 3, that is, the thickness of the layer A is 0.5 to 10 $\mu$m. When the thickness of coating 3 is greater than or equal to 0.5 $\mu$m, the decrease of a tool life due to the thin thickness of coating 3 can be prevented, and further, the effect by the layer A can be suitably exerted. When the thickness of coating 3 is less than or equal to 10 $\mu$m, the chipping resistance in an initial stage of cutting can be improved.

The thickness of coating 3 is determined as follows. First, a sample including a cross section of surface-coated cBN sintered material 1 is prepared in accordance with the procedure for determining the content ratio of cBN particles 21 described above. At this moment, a sample including a cross section of coating 3 located on the rake face 1a side, and a sample including a cross section of coating 3 located on the flank face 1b side are prepared. The cross section of surface-coated cBN sintered material 1 is observed by SEM or TEM, and each thickness of coating 3 located on the rake face 1a side and the flank face 1b side is measured at 5 points. Subsequently, the average value of the obtained 10 values is taken as the thickness of coating 3. This also applies to the thickness of each of the following layers.

The surface roughness Ra of the outermost surface of coating 3 is preferably 0.005 to 0.2 $\mu$m. According to this, the frictional force generated between surface-coated cBN sintered material 1 and the work material at the time of cutting work can be reduced, and as a result, the wear resistance of surface-coated cBN sintered material 1 can be further improved. On the other hand, in a case where the surface roughness exceeds 0.2 $\mu$m, the reduction of the frictional force becomes insufficient, and in a case where the surface roughness is less than 0.005 $\mu$m, the adhesion of coating 3 is decreased, therefore, the wear resistance is rather reduced. Note that surface roughness Ra means the arithmetic average roughness Ra of JIS B 0601 (2001), and can be measured by using a laser microscope or the like for shape measurement.

<Voids>

In the present embodiment, it is preferred that voids 23 are present when a specific region that is a cross section of surface-coated cBN sintered material 1 is observed. Further, the proportion of voids 23 in the region is preferably 0.1 to 5% by area. The presence or absence of the voids in a specific region, and the proportion are confirmed as follows.

First, an arbitrary position of surface-coated cBN sintered material 1 is cut, and a sample including a cross section of surface-coated cBN sintered material 1 is prepared. The arbitrary position at this moment is determined so that a region F (region surrounded by dashed-dotted lines in Fig. 2) that is a specific region is included in the cross section. Region F at this moment is a region sandwiched between a first virtual straight line segment $F_1$ located on an interface where one surface (rake face 2a in the present embodiment) of cBN sintered material 2 and coating 3 are in contact with each other, and having a length of 500 $\mu$m and a second virtual straight line segment $F_2$ obtained by moving first virtual straight line segment $F_1$ parallelly toward the inside (lower side in Fig. 2) of cBN sintered material 2 by 10 $\mu$m. In particular, in first virtual straight line segment $F_1$, a part to constitute a cutting edge area in rake face 2a is included.

Next, the cross section of surface-coated cBN sintered material 1 is observed by SEM at 2000 times, and a backscattered electron image is obtained. In the backscattered electron image, the region where coating 3 is present is observed as a gray or dark gray area, the region where cBN particles 21 are present is observed as a black area, the region where binder 22 is present is observed as a gray area or the white area, and the region to constitute voids 23 is observed as a deep black area. Therefore, it is confirmed that voids 23 are present in region F by recognizing the existence of the deep black area in the backscattered electron image.

Next, by performing binarization processing on the backscattered electron image with the use of image analysis software (for example, "WinROOF" by MITANI CORPORATION), the area occupied by voids 23 in region F is determined. Note that in a case where all of region F is not observed in one field of view, all of region F is observed in multiple fields of view. By substituting the obtained area occupied by voids 23 in the following equation (2), the proportion of the area of voids 23 in region F can be determined.

$$\text{(Content area ratio of voids 23 in region F)} = \text{(Area (}\mu m^2\text{) occupied by voids 23)} \div (10$$

$$\mu m \times 500\ \mu m) \times 100 \cdot \cdot \cdot \text{equation (2)}$$

Herein, as shown in Fig. 3, there is a case where "the interface between rake face 2a and coating 3 of cBN sintered material 2" meanders as observed in the cross section. In this case, a line passing through the part located on the most coating side (upper side in Fig. 2) in the interface, and parallel to the surface of coating 3 is set to be "the interface between rake face 2a and coating 3 of cBN sintered material 2" when region F described above is determined. Further, the area of voids 23 being present at the interface between cBN sintered material 2 and coating 3, that is, the area of voids 23 in contact with both of cBN sintered material 2 and coating 3 is not included in the area occupied by voids 23.

By the presence of voids 23 in region F of surface-coated cBN sintered material 1, the thermal conductivity of cBN sintered material 2 on the rake face 2a side becomes smaller. According to this, the temperature of coating 3 on the rake face 1a side at the time of cutting work is easily increased, therefore, the above-described crater wear is accelerated, and as a result, the suppressive effect on burrs is further increased. Further, in a case where voids 23 are present at the interface between cBN sintered material 2 and coating 3, coating 3 easily enters the inside of voids 23. Due to coating 3 entered the inside of voids 23 of cBN sintered material 2, an anchor effect can be exerted, and therefore, the peeling resistance of surface-coated cBN sintered material 1 is improved.

[Second embodiment]

<Surface-coated cBN sintered material>

The surface-coated cBN sintered material according to the present embodiment is different from that of the first embodiment in that coating 3 contains a layer B in addition to the layer A. Hereinafter, differences from the first embodiment will be described in detail.

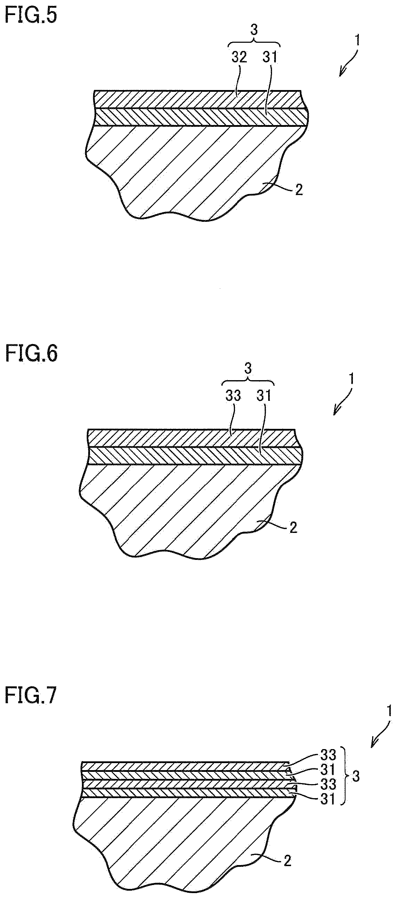

As shown in Fig. 5, coating 3 contains a layer A 31 and a layer B 32. Layer B 32 is a layer constituting the outermost surface of coating 3. Layer A 31 is similar to the layer A of the first embodiment. Layer B 32 is constituted of $Ti_{x2}Al_{y2}M_{z2}N$ (provided that M is greater than or equal to one kind of V and Si, and $0.25 \le x2 \le 0.65$, $0.35 \le y2 \le 0.75$, $0 \le z2 \le 0.2$, and $x2 + y2 + z2 = 1$ are satisfied).

Layer B 32 is excellent in the wear resistance, and further excellent in the hardness. Accordingly, surface-coated cBN sintered material 1 including coating 3 containing layer A 31 and layer B 32 is further excellent in the wear resistance.

The thickness of layer B 32 is preferably 0.1 to 10 $\mu$m. In this case, improvement of the wear resistance due to the presence of layer B 32 is particularly excellent. Further, the preferred thickness of the layer A in the first embodiment is 0.5 to 10 $\mu$m, but the thickness of layer A 31 in the present embodiment is preferably 0.1 to 10 $\mu$m. Note that the preferred thickness of coating 3 is similar to that in the first embodiment.

[Third embodiment]

<Surface-coated cBN sintered material>

The surface-coated cBN sintered material according to the present embodiment is different from that of the first embodiment in that coating 3 contains a layer C in addition to the layer A. Hereinafter, differences from the first embodiment will be described in detail.

As shown in Fig. 6, coating 3 contains layer A 31 and a layer C 33. Layer C 33 is a layer constituting the outermost surface of coating 3. Layer A 31 is similar to the layer A of the first embodiment. Layer C 33 is constituted of $Ti_{x3}M_{y3}C_{a3}N_{b3}$ (provided that M is greater than or equal to one kind of Cr, Nb, and W, and $0.3 \le x3 \le 1$, $0 <\_ y3 \le 0.7$, $x3 + y3 = 1$, $0 \le a3 \le 1$, $0 \le b3 \le 1$, and $a3 + b3 = 1$ are satisfied).

Layer C 33 is excellent in the wear resistance under a high-temperature environment. Accordingly, surface-coated cBN sintered material 1 including coating 3 containing layer A 31 and layer C 33 becomes excellent in the wear resistance particularly in the wear resistance under a high-temperature environment.

The thickness of layer C 33 is preferably 0.1 to 10 $\mu$m. In this case, improvement of the wear resistance due to the presence of layer C 33 is particularly excellent. Further, the preferred thickness of the layer A in the first embodiment is 0.5 to 10 $\mu$m, but the thickness of layer A 31 in the present embodiment is preferably 0.1 to 10 $\mu$m. Note that the preferred thickness of coating 3 is similar to that in the first embodiment.

In addition, as shown in Fig. 7, coating 3 of the present embodiment may be laminated alternately with layer A 31 and layer C 33. In Fig. 7, coating 3 is laminated alternately with two layers A 31 and two layers C 33, but the constitution of coating 3 is not limited to this. For example, coating 3 may also have a three-layer structure in which layer A 31, layer C 33, and layer A 31 are laminated in this order from the cBN sintered material 2 side, and further may also have a greater than or equal to five-layer structure.

By alternately laminating layer A 31 and layer C 33, the generation of burrs can be suppressed in a long-term cutting work. This is because by laminating a layer A being excellent in the oxidation resistance and a layer C being excellent in the thermal conductivity, the temperature rise of coating 3 is suppressed due to the effect of layer C, and as a result, the flank wear due to the oxidation of coating 3 and cBN sintered material 2 can be effectively suppressed.

In a case where coating 3 includes layer A 31 and layer C 33, and further has a laminated structure of greater than or equal to three layers, the thickness of layer C 33 is preferably 0.05 to 5 $\mu$m, the thickness of layer A 31 is preferably 0.05 to 5 $\mu$m. By having such a thickness, peeling of each layer can be suppressed. The upper limit value of the number of laminated layers in the above-described laminated structure is not particularly limited, but is 100 from the viewpoint of mass production, and the preferred range of the number of laminated layers is 4 to 20 from the viewpoint of performance.

[Fourth embodiment]

<Method for producing surface-coated cBN sintered material>

Each of the surface-coated cBN sintered materials according to the first to third present embodiments can be produced, for example, as follows.

Firstly, cBN sintered material 2 is prepared. Specifically, cBN powder to be a raw material of cBN particles 21, and compound powder to be a raw material of a binder are prepared. Next, mixed powder obtained by mixing these powders is sintered under high temperature and high pressure. As the sintering method, any one of the conventionally known methods can also be used. According to this, cBN sintered material 2 is prepared.

Next, coating 3 covers a surface (surface containing at least rake face 1a and flank face 1b constituting a cutting edge region) of cBN sintered material 2. Coating 3 can be produced by a conventionally known film forming method such as an arc ion plating method (AIP method), or a sputtering method.

For example, in the AIP method, coating 3 can be formed by using a metal evaporation source containing a metal constituting coating 3 and a reaction gas of $CH_4$, $N_2$, $O_2$ or the like. In addition, in the sputtering method, coating 3 can be formed by using a metal evaporation source containing a metal constituting coating 3, a reaction gas of $CH_4$, $N_2$, $O_2$ or the like, and a sputtering gas of Ar, Kr, Xe or the like. Note that in a case where coating 3 has a layer of greater than or equal to two layers, each layer may be formed sequentially.

[Fifth embodiment]

<Cutting tool>

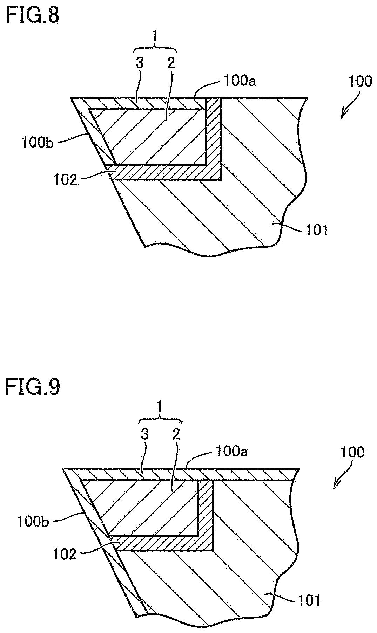

The cutting tool according to the present embodiment is a cutting tool including any one of the surface-coated cBN sintered materials of the first to third embodiments. The cutting tool according to the present embodiment will be described in detail with the use of Fig. 8.

As shown in Fig. 8, a cutting tool 100 has a base metal 101, and surface-coated cBN sintered material 1 is fixed in a predetermined region of base metal 101 with a brazed layer 102 interposed therebetween. Each shape and each material of base metal 101 and brazed layer 102 are not particularly limited, and as the shape and the material, conventionally known shapes and materials can be used.

Surface-coated cBN sintered material 1 may also be any one of the surface-coated cBN sintered materials of the first to third embodiments. Further, in Fig. 8, in surface-coated cBN sintered material 1, coating 3 is provided only on the surfaces facing rake face 100a and flank face 100b of cutting tool 100, but may be provided on all of the surfaces. In this case, coating 3 is also interposed between brazed layer 102 and cBN sintered material 2.

Cutting tool 100 can be produced, for example, as follows. Firstly, surface-coated cBN sintered material 1 is prepared in accordance with the above-described production method. Next, surface-coated cBN sintered material 1 is brazed to base metal 101. In this way, cutting tool 100 shown in Fig. 8 is produced.

Cutting tool 100 according to the present embodiment includes surface-coated cBN sintered material 1 described above, therefore, the above-described characteristics of surface-coated cBN sintered material 1 can be exhibited at the time of cutting.

In addition, in cutting tool 100 of the present embodiment, coating 3 may extend to the surface of base metal 101 as shown in Fig. 9. Cutting tool 100 shown in Fig. 9 can be produced, for example, by brazing cBN sintered material 2 to base metal 101, and then by providing coating 3 on the surfaces of cBN sintered material 2 and base metal 101.

Cutting tool 100 shown in Fig. 9 is easy to position cBN sintered material 2 as compared with cutting tool 100 shown in Fig. 8.

EXAMPLES

Hereinafter, the present invention will be described in more detail with reference to examples, however, the present invention is not limited to the following examples.

[Investigation 1]

<Fabrication of cutting tool No. 1>

(Preparation of cBN sintered material)

Firstly, Co powder (average particle diameter of 2 $\mu$m), WC powder (average particle diameter of 1 $\mu$m), and Al powder (average particle diameter of 3 $\mu$m) were mixed so that the atom ratio is 70 : 8 : 22, and the mixed powder was prepared. This mixed powder was subjected to heat treatment at 1200°C in a vacuum for 30 minutes, and then was ground. As a result, compound powder to be a raw material of a binder was obtained.
Subsequently, cBN powder including cBN particles with a d50 of 1.3 $\mu$m and a d90 of 1.9 $\mu$m, and compound powder were mixed so that the content ratio of cBN particles in the cBN sintered material is 91% by volume. In this mixing, a ball mill grinding method with the use of ball media made of boron nitride and having a diameter of 3 mm was used. The obtained mixed powder was laminated on a support substrate made of a cemented carbide, and then filled in a capsule made of Mo. Further, the above-described capsule was placed in an ultra-high pressure device, and sintered at a pressure of 6.5 GPa and a temperature of 1600°C for 30 minutes. As a result, a cBN sintered material was obtained.

(Brazing of cBN sintered material to pedestal)

The shape of the obtained cBN sintered material was formed in a triangular prism shape with an isosceles triangle having an apex angle of 55° and both sides sandwiching the apex angle of 2 mm each as the base and with a thickness of 2 mm. The obtained cBN sintered material with the triangular prism shape was bonded to a corner part of a base metal (having a shape of ISO standard DNGA 150408) including a cemented carbide material (equivalent to K10) to obtain a bonded body. Note that a brazing material made of Ti-Zr-Cu was used for the bonding. Next, the outer peripheral surface, top surface, and bottom surface of the bonded body were ground, and a negative land shape (a negative land width of 150 $\mu$m, and a negative land angle of 25°) was formed in the cutting edge. In this way, a cutting tool (but not have coating) with a cutting edge part including a cBN sintered material was obtained.

(Preparation of coating)

As a film forming device for preparing a coating, a film forming device for an AIP method was prepared. In addition, a cutting tool was placed on a table in a chamber of the film forming device, and a layer A ($Al_{0.7}Cr_{0.3}N$) having a thickness of 1.4 $\mu$m was formed under the following conditions on a surface on which the cBN sintered material had been exposed. Note that a cutting tool fabricated by this method has a coating of the constitution shown in Fig. 9.

(Film forming conditions of layer A)

Target: Al (70 atom%), and Cr (30 atom%)
Introduction gas: $N_2$
Film forming pressure: 3Pa
Arc discharge current: 150 A
Substrate bias voltage: -50 V
Table rotation speed: 2 rpm,
Film forming temperature: 580°C

Raw materials and the like used for the production of a cutting tool No. 1 are shown in Table 1. Compounds shown in columns of "X-ray detection compound" in Table 1 are compounds in the binder, being detected when a cross section of the cBN sintered material was subjected to qualitative analysis by an energy dispersive X-ray device attached with SEM ("EX-23000BU" manufactured by JEOL Ltd.). The values shown in columns of "First compound (% by mass)" in Table 1 are values obtained when the content ratio (% by mass) of the first compound contained in the binder was subjected to quantitative analysis by using the same device. Note that the first compound confirmed in No . 1 is AIN.

[Table 1]

| Sample | | cBN particle | | | Binder | | First compound (% by mass) | Coating | | Ra ($\mu$m) | Voids (% by volume) | Amount of flank wear ($\mu$m) | Cutting life (km) |
|---|---|---|---|---|---|---|---|---|---|---|---|---|---|
| | | Content (% by volume) | d50 ($\mu$m) | d90 ($\mu$m) | Mixing ratio (atom ratio) | X-ray detection compound | | Composition and structure | Thickness ($\mu$m) | | | | |
| Example | No. 1 | 91 | 1.3 | 1.9 | | $W_3Co_{21}B_6$, $W_3Co_3C$, AlN | 12 | A: $AL_{0.7}Cr_{0.3}N$ | 1.4 | 0.07 | 0.4 | 107 | 2.1 |
| | No. 2 | 81 | 1.9 | 2.9 | | | 12 | A1/C1/A2/C2/A3/C3 | A1: 0.4 | 0.1 | 0.5 | 122 | 1.6 |
| | No. 3 | 85 | 1.9 | 2.9 | | | 13 | | | 0.1 | 0.4 | 115 | 1.8 |
| | No. 4 | 93 | 1.9 | 2.9 | | | 9 | A1 to A3: $Al_{0.7}Cr_{0.3}N$ | C1: 0.2 | 0.1 | 0.6 | 105 | 2.2 |
| | No. 5 | 95 | 1.9 | 2.9 | Co (70) WC (8) | | 10 | | A2: 0.3 C2: 0.1 | 0.1 | 0.5 | 100 | 2.4 |
| | No. 6 | 98 | 1.9 | 2.9 | A1 (22) | | 12 | C1 to C3: $TiC_{0.5}N_{0.5}$ | A3: 0.3 | 0.1 | 0.5 | 123 | 1.9 |
| Comparative Example | No. 7 | 78 | 1.9 | 2.9 | | $W_3Co_{21}B_6$, $W_3Co_3C$, AlN, $Al_2O_3$ | 10 | | C3: 0.1 | 0.1 | 0.4 | 160 | 1.3 |
| | No. 8 | 99 | 1.9 | 2.9 | | Not sintered | - | - | - | - | - | - | - |
| | No. 9 | 93 | 1.9 | 2.9 | | $W_3Co_{21}B_6$, $W_3Co_3C$, AlN | 13 | No coating | - | - | - | 165 | 1.4 |

EP 3 437 770 B1

<Fabrication of cutting tools Nos. 2 to 9>

cBN Sintered materials of Nos. 2 to 9 were obtained in the similar manner as in No. 1 except that the volume content and average particle diameter of the cBN particles were changed as shown in Table 1. Further, a cutting tool was fabricated in the similar manner as in No. 1 except that the coating to form a film on the cBN sintered material was changed as shown in Table 1. (Cutting tools Nos. 2 to 6 are not according to the invention.) The film forming conditions of layers C1 to C3 ($TiC_{0.5}N_{0.5}$) were as follows. However, in No. 8, a cBN sintered material was not obtained. This is considered because the content of the binder was extremely small.

(Film forming conditions of layers C1 to C3)

    Target: Ti
    Introduction gas: $N_2$, and $CH_4$
    Film forming pressure: 2Pa
    Arc discharge current: 130 A
    Substrate bias voltage: -200 V
    Table rotation speed: 4 rpm
    Film forming temperature: 600°C

Note that the expression "A1/C1/A2/C2/A3/C3" in a column of the "Composition and structure" in Table 1 means that a coating having a six-layer structure is formed on a cBN sintered material in the order of layer A1 (layer A), layer C1 (layer C), layer A2 (layer A) • • • from the surface side of the cBN sintered material. Further, thickness of each layer is shown in a column of "Thickness".

<Characterization evaluation of Nos. 1 to 9>

With regard to each of the cutting tools Nos. 1 to 9, the surface roughness Ra (μm) of the outermost surface of a coating, and the proportion (% by area) of the voids in the above-described specific region were confirmed by the above-described method. The results are shown in Table 1.
In addition, a cutting test was performed by using each of the cutting tools Nos. 1 to 9 under the following cutting conditions. The maximum value (μm) of the amount of flank wear at the time point when burrs having a height of 0.07 mm were generated in the work material, and the cutting distance at the time point when burrs having a height of 0.07 mm were generated in the work material are shown in columns of "Amount of flank wear (μm)" and "Cutting life (km)" in Table 1.

(Cutting conditions)

    Cutting method: wet cutting
    Work material: round bar of a sintered alloy SMF4040 (material standard ISO-5755, an outer diameter of 70 mm, an inner diameter of 25 mm, and a thickness of 60 mm)
    Cutting speed: 200 mm/min
    Cutting depth: 0.2 mm
    Feed rate: 0.1 mm/rev

<Results and discussion>

With reference to Table 1, it was confirmed that as long as being a cutting tool (each of cutting tools Nos. 1 to 6) in which the proportion of cBN particles in a cBN sintered material is exceeding 80% by volume and less than or equal to 98% by volume, the binder contains a first compound, and the coating contains a layer A in contact with the cBN sintered material, the cutting tool can reduce the amount of flank wear, and further can prolong the cutting life at the time point when burrs having a height of greater than or equal to 0.07 mm are generated. As described above, according to each of the cutting tools Nos. 1 to 6, the generation of burrs in the work material was suppressed.
In addition, as compared the results of Nos. 1 to 6 with each other, with regard to the proportion of cBN particles in the cBN sintered material, the wear resistance on the flank face side became more excellent in a case where the proportion was 91 to 98% by volume, and the wear resistance on the flank face side became particularly excellent in a case where the proportion was 91 to 95% by volume.

[Investigation 2]

<Fabrication of cutting tools Nos. 10 to 17>

cBN Sintered materials of Nos. 10 to 17 were obtained in the similar manner as in No. 1 except that the volume content and average particle diameter of the cBN particles were changed as shown in Table 2. Further, a cutting tool was fabricated in the similar manner as in No. 1 except that the coating to form a film on the cBN sintered material was changed as shown in Table 2. (Cutting tool No. 13 is not according to the invention.) film forming conditions of each layer were similar to the film forming conditions of the above-described layers A and C except that the target and/or the introduction gas were changed so as to be the composition of an intended layer.

[Table 2]

| Sample | | cBN particle | | | Binder | | | Coating | | | Ra (μm) | Voids (% by volume) | Cutting life (km) |
|---|---|---|---|---|---|---|---|---|---|---|---|---|---|
| | | Content (% by volume) | d50 (μm) | d90 (μm) | Mixing ratio (atom ratio) | X-ray detection compound | First compound (% by mass) | Composition and structure | Thickness (μm) | | | | |
| Example | No. 10 | 91 | 1.9 | 2.9 | Co (70) | $W_3Co_{21}B_6$, $W_3Co_3C$, AlN | 9 | A/C<br>A: $Al_{0.3}Cr_{0.6}Ti_{0.1}C_{0.1}N_{0.9}$<br>C: $Ti_{0.9}Nb_{0.1}C_{0.5}N_{0.5}$ | A: 1<br>C: 1 | | 0.1 | 0.5 | 9.6 |
| | No. 11 | 91 | 1.9 | 2.9 | | | 11 | A/C<br>A: $Al_{0.45}Cr_{0.45}Nb_{0.1}C_{0.1}N_{0.9}$<br>C: $Ti_{0.9}Cr_{0.1}C_{0.5}N_{0.5}$ | A: 1<br>C: 1 | | 0.1 | 0.4 | 10.9 |
| | No. 12 | 91 | 1.9 | 2.9 | | | 10 | A/C<br>A: $Al_{0.55}Cr_{0.35}V_{0.1}N$<br>C: $Ti_{0.7}Cr_{0.2}V_{0.1}C_{0.4}N_{0.6}$ | A: 1<br>C: 1 | | 0.11 | 0.4 | 9.2 |
| | No. 13 | 91 | 1.3 | 1.9 | WC (8) | | 10 | A1/C1/A2/C2/A3/C3<br>A1 to $A_3$: $Al_{0.7}Cr_{0.3}N$<br>C1 to $C_3$: $TiC_{0.5}N_{0.5}$ | A1: 0.3<br>C1: 0.4<br>A2: 0.3<br>C2: 0.4<br>A3: 0.3<br>C3: 0.3 | | 0.11 | 0.4 | 11.2 |
| Comparative Example | No. 14 | 91 | 1.9 | 2.9 | Al (22) | | 11 | $Al_{0.1}Cr_{0.9}N$ | 2 | | 0.1 | 0.3 | 7.2 |
| | No. 15 | 91 | 1.9 | 2.9 | | | 9 | $Ti_{0.5}Al_{0.5}N$ | 2 | | 0.1 | 0.3 | 4.3 |
| | No. 16 | 91 | 1.9 | 2.9 | | | 12 | $Al_{0.9}Cr_{0.1}N$ | 2 | | 0.12 | 0.4 | 8.1 |
| | No. 17 | 91 | 1.3 | 1.9 | | | 11 | No coating | - | | - | 0.4 | 5.7 |

EP 3 437 770 B1

16

<Characterization evaluation of Nos. 10 to 17>

With regard to each of the cutting tools Nos. 10 to 17, the surface roughness Ra ($\mu$m) of the outermost surface of a coating, and the proportion (% by area) of the voids in the above-described specific region were confirmed by the above-described method. The results are shown in Table 2.

In addition, a cutting test was performed by using each of the cutting tools Nos. 10 to 17 under the following cutting conditions. The cutting distance at the time point when burrs having a height of 0.1 mm were generated in the work material is shown in a column of "Cutting life (km)" in Table 2.

(Cutting conditions)

Cutting method: wet cutting
Work material: sprocket A equivalent to a material SMF4040 (material standard ISO-5755 (F-08C2), an outer diameter of 40 mm, an inner diameter of 20 mm, a thickness of 50 mm, and the number of teeth of 8)
Cutting speed: 130 mm/min
Cutting depth: 0.1 mm
Feed rate: 0.2 mm/rev

<Results and discussion>

With reference to Table 2, it was confirmed that the generation of burrs is suppressed in a cutting tool (each of cutting tools Nos. 10 to 17) in which the proportion of cBN particles in a cBN sintered material is exceeding 80% by volume and less than or equal to 98% by volume, the binder contains a first compound, and the coating contains a layer A in contact with the cBN sintered material.

[Investigation 3]

<Fabrication of cutting tools Nos. 18 to 27>

cBN Sintered materials of Nos. 18 to 27 were obtained in the similar manner as in No. 1 except that the volume content and average particle diameter of the cBN particles were changed and the mixing ratio of the compound powder to be a raw material of the binder was changed as shown in Table 3. Further, a cutting tool was fabricated in the similar manner as in No. 1 except that the coating to form a film on the cBN sintered material was changed as shown in Table 3. The film forming conditions of each layer were similar to the film forming conditions of the above-described layers A and C except that the target and/or the introduction gas were changed so as to be the composition of an intended layer.

[Table 3]

| Sample | | cBN particle | | | Binder | | | Coating | | Ra (μm) | Voids (% by volume) | Amount of flank wear (μm) | Burr height (mm) |
|---|---|---|---|---|---|---|---|---|---|---|---|---|---|
| | | Content (% by volume) | d50 (μm) | d90 (μm) | Mixing ratio (atom ratio) | X-ray detection compound | First compound (% by mass) | Composition and structure | Thickness (μm) | | | | |
| Example | No. 18 | 90 | 0.9 | 1.7 | Co (89), wc (9), Al (2) | $W_3Co_{21}B_6$, $W_3Co_3C$, AlN | 0.5 | A/B | A: 1.4 | 0.1 | 0.9 | 147 | 0.14 |
| | No. 19 | | | | Co (39), WC (2), Al (59) | $W_3Co_{21}B_6$, $W_3Co_3C$, AlN | 47 | | | 0.1 | 0.9 | 132 | 0.13 |
| | No. 20 | | | | AlCrN (83), Al (17) | AlCrN, AlN, $Al_2O_3$ | 100 | | | 0.1 | 0.9 | 140 | 0.14 |
| | No. 21 | | | | Co (28), WC (3), Al (9), AlCrN (60) | $W_3Co_{21}B_6$ $W_3Co_3C$, AlCrN, AlN | 63 | | | 0.1 | 1 | 123 | 0.10 |
| | No. 22 | | | | Co (21), WC (3), Al (6), CrN (10), AlCrN (60) | $W_3Co_{21}B_6$, $W_3Co_3C$, AlCrN, AlN, CrN | 70 | A: $Al_{0.65}Cr_{0.35}N$ | | 0.1 | 1 | 131 | 0.11 |
| | No. 23 | | | | Co (18), WC (2), AlN (40), CrN (40) | $W_3Co_{21}B_6$, $W_3Co_3C$, CrN, AlN | 67 | B: $Ti_{0.5}Al_{0.5}N$ | | 0.1 | 1 | 128 | 0.11 |
| | No. 24 | | | | Co (27), WC (2), CrN (71) | $W_3Co_{21}B_6$, $W_3Co_3C$, CrN | 56 | | | 0.1 | 0.9 | 135 | 0.14 |
| | No. 25 | | | | Co (9), Ni (9), WC (3), CrN (79) | $W_3Co_{21}B_6$, $W_3Co_3C$, CrN | 62 | | B: 0.6 | 0.1 | 1 | 138 | 0.14 |
| | No. 26 | | | | AlCrN | AlCrN | 100 | | | 0.1 | 0.9 | 115 | 0.10 |
| | No. 27 | | | | Co (90), WC (9), Al (1) | $W_3Co_{21}B_6$, $W_3Co_3C$, AlN | 0.3 | | | 0.1 | 1 | 316 | 0.28 |

<Characterization evaluation of Nos. 18 to 27>

With regard to each of the cutting tools Nos. 18 to 27, the surface roughness Ra ($\mu$m) of the outermost surface of a coating, and the proportion (% by area) of the voids in the above-described specific region were confirmed by the above-described method. The results are shown in Table 3.

In addition, a cutting test was performed by using each of the cutting tools Nos. 18 to 27 under the following cutting conditions. The maximum value ($\mu$m) of the amount of flank wear and the largest burr height (mm) among the burrs confirmed on a surface of the work material after 20 passes cutting are shown in columns of "Amount of flank wear ($\mu$m)" and "Burr height (mm)" in Table 3.

(Cutting conditions)

Cutting method: dry cutting
Work material: sprocket B equivalent to a material SMF4040 (material standard ISO-5755 (F-08C2), an outer diameter of 135 mm, an inner diameter of 60 mm, a thickness of 20 mm, and the number of teeth of 16)
Cutting speed: 120 mm/min
Cutting depth: 0.2 mm
Feed rate: 0.15 mm/rev

<Results and discussion>

With reference to Table 3, it was found that in a case where the content ratio of the first compound in the binder of the cBN sintered material was 0.5 to 100% by mass, the wear resistance was particularly excellent. Further, when the presence or absence of the peeling of the coating was observed, the peeling was confirmed in a case where the content ratio of the first compound was 0.3% by mass.

[Investigation 4]

<Fabrication of cutting tools Nos. 28 to 32>

cBN Sintered materials of Nos. 28 to 32 were obtained in the similar manner as in No. 1 except that the volume content and average particle diameter of the cBN particles were changed as shown in Table 4. Further, a cutting tool was fabricated in the similar manner as in No. 1 except that the coating to form a film on the cBN sintered material was changed as shown in Table 4. The film forming conditions of layer A were similar to the film forming conditions of the above-described layer A except that the introduction gas and the target were changed so as to be the composition of an intended layer, and further the film forming temperature was set to be 630°C.

(Introduction gas and target in film forming of layer A)

Introduction gas: $N_2$, and $O_2$
Target: Al (50 atom%), and Cr (50 atom%)

[Table 4]

| Sample | | cBN particle | | | Binder | | | Coating | | Ra ($\mu$m) | Voids (% by volume) | Amount of flank wear ($\mu$m) | Burr height |
|---|---|---|---|---|---|---|---|---|---|---|---|---|---|
| | | Content (% by volume) | d50 ($\mu$m) | d90 ($\mu$m) | Mixing ratio (atom ratio) | X-ray detection compound | First compound (% by mass) | Composition and structure | Thickness ($\mu$m) | | | | |
| Example | No. 28 | 91 | 0.8 | 1.5 | Co (70)  WC (8)  Al (22) | $W_3Co_{21}B_6$, $W_3Co_3C$, AlN | 12 | A: $Al_{0.5}Cr_{0.5}N_{0.95}O_{0.05}$ | 1.9 | 0.1 | 0.1 | 183 | 0.11 |
| | No. 29 | 91 | 0.8 | 1.5 | | | 10 | | | 0.1 | 2.3 | 148 | 0.09 |
| | No. 30 | 85 | 0.8 | 1.5 | | | 10 | | | 0.1 | 5 | 130 | 0.08 |
| | No. 31 | 91 | 0.8 | 1.5 | | | 11 | | | 0.1 | 0.03 | 210 | 0.17 |
| | No. 32 | 85 | 0.8 | 1.5 | | | 9 | | | 0.1 | 5.4 | 298 | 0.22 |

<Characterization evaluation of Nos. 28 to 32>

With regard to each of the cutting tools Nos. 28 to 32, the surface roughness Ra ($\mu$m) of the outermost surface of a coating, and the proportion (% by area) of the voids in the above-described specific region were confirmed by the above-described method. The results are shown in Table 4.

In addition, a cutting test was performed by using each of the cutting tools Nos. 28 to 32 under the following cutting conditions. The maximum value ($\mu$m) of the amount of flank wear and the largest burr height (mm) among the burrs confirmed on a surface of the work material after 20 passes cutting are shown in columns of "Amount of flank wear ($\mu$m)" and "Burr height (mm)" in Table 4.

(Cutting conditions)

Cutting method: dry cutting
Work material: sprocket B (similar to the above)
Cutting speed: 150 mm/min
Cutting depth: 0.2 mm
Feed rate: 0.2 mm/rev

<Results and discussion>

With reference to Table 4, it was found that in the surface-coated cBN sintered material, in a case where the proportion of the voids in the specific region was 0.1 to 5% by area, the wear resistance was particularly excellent, and further the generation of burrs in the work material was suppressed. Further, when the presence or absence of the peeling of the coating was observed, the peeling was observed in a case where the proportion of the voids was 0.03% by area and 5.4% by area.

[Investigation 5]

<Fabrication of cutting tools Nos. 33 to 37> (not according to the invention)

cBN Sintered materials of Nos. 33 to 37 were obtained in the similar manner as in No. 1 except that the volume content and average particle diameter of the cBN particles were changed as shown in Table 5. Further, a cutting tool was fabricated in the similar manner as in No. 1 except that the coating to form a film on the cBN sintered material was changed as shown in Table 5. The film forming conditions of the layer A were similar to the film forming conditions of the above-described layer A except that the introduction gas and the target were changed so as to be the composition of an intended layer, and further the film forming temperature was set to be 650°C.

(Introduction gas and target in film forming of layer A)

Introduction gas: $N_2$, and $O_2$
Target: Al (40 atom%), Cr (53 atom%), and Si (7 atom%)

[Table 5]

| Sample | | cBN particle | | | Binder | | | Coating | | Ra ($\mu$m) | Voids (% by volume) | Amount of flank wear ($\mu$m) | Burr height (mm) |
|---|---|---|---|---|---|---|---|---|---|---|---|---|---|
| | | Content (% by volume) | d50 ($\mu$m) | d90 ($\mu$m) | Raw material powder | X-ray detection compound | First compound (% by mass) | Composition and structure | Thickness ($\mu$m) | | | | |
| Example | No. 33 | 91 | 1.8 | 2.7 | Co (70), WC (8) Al (22) | cBN, $W_3Co_{21}B_6$, $W_3Co_3C$, AlN | 11 | A: $Al_{0.4}Cr_{0.53}Si_{0.07}N$<br><br>B: $Ti_{0.9}W_{0.1}N$ | 1.5<br><br>Each 0.1 15 times)layer $\mu$m (laminated | 0.005 | 0.4 | 152 | 0.11 |
| | No. 34 | | | | | | 11 | | | 0.1 | 0.4 | 153 | 0.11 |
| | No. 35 | | | | | | 10 | | | 0.2 | 0.4 | 160 | 0.12 |
| | No. 36 | | | | | | 11 | | | 0.003 | 0.4 | 177 | 0.15 |
| | No. 37 | | | | | | 12 | | | 0.3 | 0.4 | 191 | 0.17 |

<Characterization evaluation of Nos. 33 to 37>

With regard to each of the cutting tools Nos. 33 to 37, the surface roughness Ra ($\mu$m) of the outermost surface of a coating, and the proportion (% by area) of the voids in the above-described specific region were confirmed by the above-described method. The results are shown in Table 5.

In addition, a cutting test was performed by using each of the cutting tools Nos. 33 to 37 under the following cutting conditions. The maximum value ($\mu$m) of the amount of flank wear and the largest burr height (mm) among the burrs confirmed on a surface of the work material are shown in columns of "Amount of flank wear ($\mu$m)" and "Burr height (mm)" in Table 5.

(Cutting conditions)

Cutting method: dry cutting
Work material: sprocket C equivalent to a material SMF4040 (material standard ISO-5755 (F-08C2), an outer diameter of 135 mm, an inner diameter of 60 mm, a thickness of 20 mm, the number of teeth of 16, and induction hardening treatment is applied on the outer peripheral part)
Cutting speed: 200 mm/min
Cutting depth: 0.2 mm
Feed rate: 0.2 mm/rev
Evaluation method: amount of flank wear VB after 40 passes processing

<Results and discussion>

With reference to Table 5, it was found that in the surface-coated cBN sintered material, in a case where the surface roughness Ra of the coating was 0.005 to 0.2, the wear resistance was particularly excellent, and further the generation of burrs in the work material was suppressed. Further, when the presence or absence of the peeling of the coating was observed, the peeling was confirmed in a case where Ra was 0.003.

The embodiments and examples disclosed herein are examples in all respects, and should not be considered to be restrictive. The scope of the present invention is indicated not by the above-described embodiments and examples but by the scope of claims.

REFERENCE SIGNS LIST

1: surface-coated cBN sintered material, 2: cBN sintered material, 3: coating, 21: cBN particles, 22: binder, 23: voids, 31: layer A, 32: layer B, 33: layer C, 100: cutting tool, 101: base metal, 102: brazed layer, 1a, 2a, and 100a: rake face, 1b, 2b, and 100b: flank face

**Claims**

1. A surface-coated cubic boron nitride sintered material, comprising:

    a cubic boron nitride sintered material having a rake face and a flank face;
    a coating covering a surface of said cubic boron nitride sintered material, wherein
    said cubic boron nitride sintered material contains a cubic boron nitride particle and a binder,
    a proportion of said cubic boron nitride particle in said cubic boron nitride sintered material is more than or equal to 85% by volume and less than or equal to 98% by volume,
    said binder contains a first compound including at least one element of Al and Cr and at least one element selected from the group consisting of N, B and O,
    said coating contains a layer A in contact with said cubic boron nitride sintered material,
    said layer A is constituted of $Al_{x1}Cr_{y1}M_{z1}C_{a1}N_{b1}O_{c1}$ provided that M is greater than or equal to one kind of Ti, V, Nb and Si, and $0.25 \leq x1 \leq 0.75$, $0.25 \leq y1 \leq 0.75$, $0 \leq z1 \leq 0.5$, $x1 + y1 + z1 = 1$, $0 \leq a1 \leq 0.5$, $0.5 \leq b1 \leq 1$, $0 \leq c1 \leq 0.1$, and $a1 + b1 + c1 = 1$ are satisfied,
    the thickness of said layer A is 0.5 to 10 $\mu$m.

2. The surface-coated cubic boron nitride sintered material according to claim 1, wherein

a proportion of said cubic boron nitride particle in said cubic boron nitride sintered material is greater than or equal to 90% by volume and less than or equal to 98% by volume.

3. The surface-coated cubic boron nitride sintered material according to claim 1 or 2, wherein said binder contains a second compound including at least one element of W and Co and at least one element selected from the group consisting of N, B and O.

4. The surface-coated cubic boron nitride sintered material according to any one of claims 1 to 3, wherein a proportion of said first compound in said binder is greater than or equal to 0.5% by mass and less than or equal to 100% by mass.

5. The surface-coated cubic boron nitride sintered material according to any one of claims 1 to 4, wherein said first compound is at least one kind selected from the group consisting of AlCrN, AlN, and CrN.

6. The surface-coated cubic boron nitride sintered material according to any one of claims 1 to 5, wherein

in a cross section of said surface-coated cubic boron nitride sintered material, voids are present in the region sandwiched between a first virtual straight line segment located on an interface where one surface of said cubic boron nitride sintered material and said coating are in contact with each other and having a length of 500 $\mu$m, and a second virtual straight line segment obtained by moving said first virtual straight line segment parallelly toward the inside of said cubic boron nitride sintered material by 10 $\mu$m,
and a proportion of said voids in the said region is greater than or equal to 0.1% by area and less than or equal to 5% by area.

7. The surface-coated cubic boron nitride sintered material according to any one of claims 1 to 6, wherein surface roughness Ra of the outermost surface of said coating is greater than or equal to 0.005 $\mu$m and less than or equal to 0.2 $\mu$m.

8. The surface-coated cubic boron nitride sintered material according to any one of claims 1 to 7, wherein

said coating further contains a layer B, and
said layer B is constituted of $Ti_{x2}Al_{y2}M_{z2}N$ provided that M is greater than or equal to one kind of V and Si, and $0.25 \leq x2 \leq 0.65$, $0.35 \leq y2 \leq 0.75$, $0 \leq z2 \leq 0.2$, and $x2 + y2 + z2 = 1$ are satisfied.

9. The surface-coated cubic boron nitride sintered material according to any one of claims 1 to 8, wherein

said coating further contains a layer C, and
said layer C is constituted of $Ti_{x3}M_{y3}C_{a3}N_{b3}$ provided that M is greater than or equal to one kind of Cr, Nb, and W, and $0.3 \leq x3 \leq 1$, $0 \leq y3 \leq 0.7$, $x3 + y3 = 1$, $0 \leq a3 \leq 1$, $0 \leq b3 \leq 1$, and $a3 + b3 = 1$ are satisfied.

10. A cutting tool, comprising the surface-coated cubic boron nitride sintered material according to any one of claims 1 to 9.


**Patentansprüche**

1. Oberflächenbeschichtetes Sintermaterial aus kubischem Bornitrid, umfassend

ein Sintermaterial aus kubischem Bornitrid mit einer Spanfläche und einer Flankenfläche;
eine Beschichtung, die eine Oberfläche des Sintermaterials aus kubischem Bornitrid bedeckt, wobei
das Sintermaterial aus kubischem Bornitrid ein Partikel aus kubischem Bornitrid und ein Bindemittel enthält,
ein Anteil des Partikels aus kubischem Bornitrid in dem Sintermaterial aus kubischem Bornitrid mehr als oder gleich 85 Vol.-% und weniger als oder gleich 98 Vol.-% beträgt,
das Bindemittel eine erste Verbindung enthält, umfassend mindestens ein Element aus Al und Cr und mindestens ein Element, ausgewählt aus der Gruppe, bestehend aus N, B und O,
wobei die Beschichtung eine Schicht A enthält, die mit dem Sintermaterial aus kubischem Bornitrid in Kontakt steht,
die Schicht A aus $Al_{x1}Cr_{y1}M_{z1}C_{a1}N_{b1}O_{c1}$ besteht, mit der Maßgabe, dass M größer als oder gleich einer Art von Ti, V, Nb und Si ist, und dass $0,25 \leq x1 \leq 0,75$, $0,25 \leq y1 \leq 0,75$, $0 \leq z1 \leq 0,5$, $x1 + y1 + z1 = 1$, $0 \leq a1 \leq$

0,5, $0,5 \leq b1 \leq 1$, $0 \leq c1 \leq 0,1$ und a1 + b1 + c1 = 1 erfüllt sind,
die Dicke der Schicht A 0,5 bis 10 $\mu$m beträgt.

2. Oberflächenbeschichtetes Sintermaterial aus kubischem Bornitrid nach Anspruch 1, wobei
ein Anteil der Partikel aus kubischem Bornitrid in dem Sintermaterial aus kubischem Bornitrid mehr als oder gleich 90 Vol.-% und weniger als oder gleich 98 Vol.-% beträgt.

3. Oberflächenbeschichtetes Sintermaterial aus kubischem Bornitrid nach Anspruch 1 oder 2, wobei
das Bindemittel eine zweite Verbindung enthält, umfassend mindestens ein Element aus W und Co und mindestens ein Element, ausgewählt aus der Gruppe, bestehend aus N, B und O, enthält.

4. Oberflächenbeschichtetes Sintermaterial aus kubischem Bornitrid nach einem der Ansprüche 1 bis 3, wobei
der Anteil der ersten Verbindung in dem Bindemittel größer als oder gleich 0,5 Massen-% und kleiner als oder gleich 100 Massen-% ist.

5. Oberflächenbeschichtetes Sintermaterial aus kubischem Bornitrid nach einem der Ansprüche 1 bis 4, wobei
die erste Verbindung mindestens eine Art ist, ausgewählt aus der Gruppe, bestehend aus AlCrN, AlN und CrN.

6. Oberflächenbeschichtetes Sintermaterial aus kubischem Bornitrid nach einem der Ansprüche 1 bis 5, wobei

in einem Querschnitt des oberflächenbeschichteten Sintermaterials aus kubischem Bornitrid Hohlräume in dem Bereich vorhanden sind, der zwischen einem ersten virtuellen geraden Liniensegment, das sich an einer Grenzfläche befindet, an der eine Oberfläche des Sintermaterials aus kubischem Bornitrid und die Beschichtung miteinander in Kontakt stehen, und das eine Länge von 500 $\mu$m aufweist, und einem zweiten virtuellen geraden Liniensegment, das durch Verschieben des ersten virtuellen geraden Liniensegments parallel zur Innenseite des Sintermaterials aus kubischem Bornitrid um 10 $\mu$m erhalten wird, liegt,
und ein Anteil der Hohlräume in diesem Bereich größer oder gleich 0,1 % der Fläche und kleiner oder gleich 5 % der Fläche ist.

7. Oberflächenbeschichtetes Sintermaterial aus kubischem Bornitrid nach einem der Ansprüche 1 bis 6, wobei
die Oberflächenrauheit Ra der äußersten Oberfläche der Beschichtung größer als oder gleich 0,005 $\mu$m und kleiner als oder gleich 0,2 $\mu$m ist.

8. Oberflächenbeschichtetes Sintermaterial aus kubischem Bornitrid nach einem der Ansprüche 1 bis 7, wobei

die Beschichtung ferner eine Schicht B enthält, und
die Schicht B aus $Ti_{x2}Al_{y2}M_{z2}N$ besteht, mit der Maßgabe, dass M größer oder gleich einer Art von V und Si ist und dass $0,25 \leq x2 \leq 0,65$, $0,35 \leq y2 \leq 0,75$, $0 \leq z2 \leq 0,2$ und x2 + y2 + z2 = 1 erfüllt sind.

9. Oberflächenbeschichtetes Sintermaterial aus kubischem Bornitrid nach einem der Ansprüche 1 bis 8, wobei

die Beschichtung weiterhin eine Schicht C enthält, und
die Schicht C aus $Ti_{x3}M_{y3}C_{a3}N_{b3}$ besteht, unter der Maßgabe, dass M größer oder gleich einer Art von Cr, Nb und W ist und dass $0,3 \leq x3 \leq 1$, $0 \leq y3 \leq 0,7$, x3 + y3 = 1, $0 \leq a3 \leq 1$, $0 \leq b3 \leq 1$ und a3 + b3 = 1 erfüllt sind.

10. Schneidwerkzeug, umfassend den oberflächenbeschichteten Sinterwerkstoff aus kubischem Bornitrid nach einem der Ansprüche 1 bis 9.

**Revendications**

1. Matériau fritté en nitrure de bore cubique revêtu en surface, comprenant :

un matériau fritté en nitrure de bore cubique ayant une face de coupe et une face de flanc ;
un revêtement recouvrant une surface dudit matériau fritté en nitrure de bore cubique, dans lequel
ledit matériau fritté en nitrure de bore cubique contient une particule de nitrure de bore cubique et un liant,
une proportion de ladite particule en nitrure de bore cubique dans ledit matériau fritté en nitrure de bore cubique est supérieure ou égale à 85 % en volume et inférieure ou égale à 98 % en volume,

ledit liant contient un premier composé incluant au moins un élément de Al et Cr et au moins un élément choisi dans le groupe consistant en N, B et O,
ledit revêtement contient une couche A en contact avec ledit matériau fritté en nitrure de bore cubique,
ladite couche A est constituée de $Al_{x1}Cr_{y1}M_{z1}C_{a1}N_{b1}O_{c1}$ à condition que M soit supérieur ou égal à un type de Ti, V, Nb et Si, et $0,25 \leq x1 \leq 0,75$, $0,25 \leq y1 \leq 0,75$, $0 \leq z1 \leq 0,5$, $x1 + y1 + z1 = 1$, $0 \leq a1 \leq 0,5$, $0,5 \leq b1 \leq 1$, $0 \leq c1 \leq 0,1$, et $a1 + b1 + c1 = 1$ sont satisfaits,
l'épaisseur de ladite couche A est de 0,5 à 10 $\mu$m.

2. Matériau fritté en nitrure de bore cubique revêtu en surface selon la revendication 1, dans lequel une proportion de ladite particule en nitrure de bore cubique dans ledit matériau fritté en nitrure de bore cubique est supérieure ou égale à 90 % en volume et inférieure ou égale à 98 % en volume.

3. Matériau fritté en nitrure de bore cubique revêtu en surface selon la revendication 1 ou 2, dans lequel ledit liant contient un second composé incluant au moins un élément de W et Co et au moins un élément choisi dans le groupe consistant en N, B et O.

4. Matériau fritté en nitrure de bore cubique revêtu en surface selon l'une quelconque des revendications 1 à 3, dans lequel une proportion dudit premier composé dans ledit liant est supérieure ou égale à 0,5 % en masse et inférieure ou égale à 100 % en masse.

5. Matériau fritté en nitrure de bore cubique revêtu en surface selon l'une quelconque des revendications 1 à 4, dans lequel ledit premier composé est au moins un type choisi dans le groupe consistant en AlCrN, AlN, et CrN.

6. Matériau fritté en nitrure de bore cubique revêtu en surface selon l'une quelconque des revendications 1 à 5, dans lequel
dans une section transversale dudit matériau fritté en nitrure de bore cubique revêtu en surface, des vides sont présents dans la région intercalée entre un premier segment de ligne droite virtuelle disposé sur une interface où une surface dudit matériau fritté en nitrure de bore cubique et ledit revêtement sont en contact l'un avec l'autre et ayant une longueur de 500 $\mu$m, et un second segment de ligne droite virtuelle obtenu en déplaçant ledit premier segment de ligne droite virtuelle parallèlement vers l'intérieur dudit matériau fritté en nitrure de bore cubique de 10 $\mu$m,
et une proportion desdits vides dans ladite région est supérieure ou égale à 0,1 % par surface et inférieure ou égale à 5 % par surface.

7. Matériau fritté en nitrure de bore cubique revêtu en surface selon l'une quelconque des revendications 1 à 6, dans lequel une rugosité de surface Ra de la surface extérieure dudit revêtement est supérieure ou égale à 0,005 $\mu$m et inférieure ou égale à 0,2 $\mu$m.

8. Matériau fritté en nitrure de bore cubique revêtu en surface selon l'une quelconque des revendications 1 à 7, dans lequel
ledit revêtement contient de plus une couche B, et
ladite couche B est constituée de $Ti_{x2}Al_{y2}M_{z2}N$ à condition que M soit supérieur ou égal à un type de V et Si, et $0,25 \leq x2 \leq 0,65$, $0,35 \leq y2 \leq 0,75$, $0 \leq z2 \leq 0,2$, et $x2 + y2 + z2 = 1$ sont satisfaits.

9. Matériau fritté en nitrure de bore cubique revêtu en surface selon l'une quelconque des revendications 1 à 8, dans lequel
ledit revêtement contient de plus une couche C, et
ladite couche C est constituée de $Ti_{x3}M_{y3}C_{a3}N_{b3}$ à condition que M soit supérieur ou égal à un type de Cr, Nb, et W, et $0,3 \leq x3 \leq 1$, $0 \leq y3 \leq 0,7$, $x3 + y3 = 1$, $0 \leq a3 \leq 1$, $0 \leq b3 \leq 1$, et $a3 + b3 = 1$ sont satisfaits.

10. Outil de coupe, comprenant le matériau fritté en nitrure de bore cubique revêtu en surface selon l'une quelconque des revendications 1 à 9.

**FIG.1**

**FIG.2**

FIG.3

FIG.4

FIG.5

FIG.6

FIG.7

FIG.8

FIG.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009095889 A
- JP 2015085465 A

- US 2013108850 A